# EUROPÄISCHE PATENTSCHRIFT

(11) **EP 2 115 767 B1**
(45) Veröffentlichungstag und Bekanntmachung des Hinweises auf die Patenterteilung: **06.04.2011**
(21) Anmeldenummer: 08708180.8
(22) Anmeldetag: 25.01.2008
(51) Int. Cl.: H01L 21/00, H05K 13/04, H05K 13/08

(54) **VORRICHTUNG FÜR DIE MONTAGE EINES FLIPCHIPS AUF EINEM SUBSTRAT**
DEVICE FOR MOUNTING A FLIP-CHIP ON A SUBSTRATE
DISPOSITIF POUR LE MONTAGE D'UNE PUCE RETOURNÉE SUR UN SUBSTRAT

(30) Priorität: 31.01.2007 CH 158072007
(43) Veröffentlichungstag der Anmeldung: 11.11.2009
(73) Patentinhaber: Esec AG, 6330 Cham (CH)
(72) Erfinder: GRUETER, Ruedi, 6018 Buttisholz (CH); BLESSING, Patrick, 8800 Thalwil (CH); WERNE, Dominik, 6315 Oberaegeri (CH)
(74) Vertreter: Falk, Urs
(86) Internationale Anmeldenummer: PCT/EP2008/050841
(87) Internationale Veröffentlichungsnummer: WO 2008/092798

(56) Entgegenhaltungen:
- WO-A-01/67831
- DE-U1- 20 019 096
- US-A- 5 195 234

## Beschreibung

### Technisches Gebiet

Die Erfindung betrifft eine Vorrichtung für die Montage eines Flipchips auf einem Substrat der im Anspruch 1 genannten Art. Ein Flipchip ist ein Halbleiterchip, der eine Oberfläche mit sogenannten Bumps aufweist, über die die elektrischen Verbindungen mit dem Substrat hergestellt werden.

### Hintergrund der Erfindung

Bei der Montage der Halbleiterchips auf einem Substrat wird das Substrat in der Regel auf einer horizontal ausgerichteten Auflagefläche bereitgestellt und die Halbleiterchips werden auf einem Wafertisch bereitgestellt, wobei die elektrischen Anschlussflächen der Halbleiterchips nach oben zeigen. Der Halbleiterchip wird von einem Bondkopf eines Montageautomaten, eines sogenannten Die Bonders, vom Wafertisch entnommen und auf dem Substrat platziert. Dieses Montageverfahren ist in der Fachwelt als Epoxy Die Bonding oder Sortsolder Die Bonding bekannt, je nachdem ob der Halbleiterchip mit Epoxy auf das Substrat geklebt oder mit Lot auf das Substrat gelötet wird. Von diesem Montageverfahren unterscheidet sich das Flipchip Verfahren, bei dem die elektrische wie auch die mechanische Verbindung zwischen dem Halbleiterchip und dem Substrat über die Bumps hergestellt wird. Damit der Halbleiterchip mit den Bumps montiert werden kann, muss er nach der Entnahme vom Wafertisch um 180° gewendet (geflippt) werden, daher der Name Flipchip.

Beim Flipchip Verfahren müssen die Bumps des Halbleiterchips in Kontakt mit den elektrischen Anschlussflächen des Substrats, den sogenannten Pads, gebracht werden. Die Anforderungen an die Platzierungsgenauigkeit sind beim Flipchip Verfahren deshalb um einiges grösser als beim Epoxy Die Bonding. Ein Montageautomat für die Montage von Flipchips umfasst eine Flipvorrichtung, die den Halbleiterchip vom Wafertisch entnimmt und wendet, eine Pick and Place Einrichtung mit einem Bondkopf, der den gefluppten Halbleiterchip von der Flipvorrichtung übernimmt und auf dem Substrat platziert, und drei Kameras wobei die erste Kamera ein Bild des auf dem Wafertisch präsentierten Halbleiterchips die zweite Kamera ein Bild des vom Bondkopf aufgenommenen, bereits gewendeten Halbleiterchips und somit Flipchips, d.h. ein Bild der mit den Bumps versehenen Oberfläche des Halbleiterchips, und die dritte Kamera ein Bild des Substrats mit den Pads aufnimmt. Das Bild der ersten Kamera wird verwendet, um die Lage des vom Wafertisch bereitgestellten Halbleiterchips zu überprüfen und allenfalls, den Wafertisch neu zu positionieren, damit die Flipvorrichtung den Halbleiterchip übernehmen und an den Bondkopt übergeben kann. Die Bilder der zweiten und dritten Kamera werden verwendet, um die Lage des Flipchips und die Lage des Substrats zu bestimmen, damit der Bondkopf den Flipchip lagegenau auf dem Substrat platzieren kann.

Es wird ebenso Bezug genommen auf den Stand der Technik in den jeweiligen Dokumenten US-A-5,195,234; WO-A-01/67831 und DE 20019096 U1.

### Kurze Beschreibung der Erfindung

Der Erfindung liegt die Erkenntnis zugrunde, dass die Aufgaben der ersten und zweiten Kamera von einer einzigen Kamera wahrgenommen werden können, ohne dass technische oder prozessrelevante Nachteile entstehen.

Die Erfindung betrifft eine Vorrichtung für die Montage von Halbleiterchips als Flipchip auf einem Substrat. Die Vorrichtung umfasst Mittel für die Zuführung der Halbleiterchips an eine vorbestimmte Position, beispielsweise einen Wafertisch oder ein Waffelpack, etc. Die Vorrichtung umfasst weiter ein Pick and Place System mit einem Bondkopf mit einem Chipgreifer, eine Flipvorrichtung mit einem Greifer und zwei Kameras. Der Greifer der Flipvorrichtung ist um eine vorbestimmte Achse drehbar gelagert und dient dazu, in einer ersten Drehlage den von den genannten Mitteln bereitgestellten Halbleiterchip vom Wafer aufzunehmen, und in einer zweiten Drehlage als Flipchip an den Chipgreifer des Bondkopfs zu übergeben. Die erste Kamera dient einerseits dazu, die Ist-Lage des von den genannten Mitteln für die Montage bereitgestellten Halbleiterchips auf dem Wafer zu bestimmen, bevor die Flipvorrichtung den Halbleiterchip aufnimmt, und sie dient andererseits dazu, die Ist-Lage des vom Chipgreifer des Bondkopfs aufgenommenen Flipchips zu bestimmen, nachdem die Flipvorrichtung den Halbleiterchip übergeben hat. Die zweite Kamera dient dazu, die Lage des Substratplatzes zu bestimmen. Die Vorrichtung umfasst erfindungsgemäss einen optischen Schalter, der dazu dient, für die erste Kamera abwechslungsweise ein erstes oder ein zweites Blickfeld einzustellen, wobei sich der von den genannten Mitteln bereitgestellte Halbleiterchip im ersten Blickfeld und der vom Chipgreifer gehaltene Halbleiterchip im zweiten Blickfeld befindet. Die Flipvorrichtung und der optische Schalter sind miteinander wirkverbunden dergestalt, dass bei einem Wechsel der Flipvorrichtung von der ersten Drehlage in die zweite Drehlage das Blickfeld der Kamera vom ersten Blickfeld zum zweiten Blickfeld wechselt. Die Wirkverbindung zwischen der Flipvorrichtung und dem optischen Schalter ist vorzugsweise eine mechanische Wirkverbindung.

Der optische Schalter umfasst beispielsweise einen um eine vorbestimmte Achse drehbar gelagerten Spiegel, der sich vor der ersten Kamera befindet. Der Spiegel wird im Betrieb jeweils gleichzeitig mit dem Greifer der Flipvorrichtung gedreht, jedoch nur um den halben Winkel. D.h. wenn der Greifer um den Winkel θ gedreht wird, wird der Spiegel um den Winkel θ/2 gedreht. Das Drehen des Spiegels erfolgt bevorzugt mittels zweier Hebel, die sich in Strecklage zueinander befinden, wenn der Spiegel die eine oder andere Endposition erreicht hat.

Die Vorrichtung kann alternativ ein Farbfilterkreuz umfassen, das einerseits den von den genannten Mitteln an der vorbestimmten Position bereitgestellten Halbleiterchip in einer ersten Farbe auf die Kamera abbildet und das andererseits den vom Chipgreifer gehaltenen Halbleiterchip in einer anderen, zweiten Farbe auf die Kamera abbildet. Der optische Schalter besteht in diesem Fall aus zwei Farbfiltern, von denen der eine für die erste Farbe und der andere für die zweite Farbe durchlässig ist. Bei einem Wechsel der Drehlage der Flipvorrichtung wird automatisch der eine oder andere Farbfilter in den Strahlengang der Kamera gebracht, so dass das Blickfeld der Kamera wechselt. Anstelle der Farbfilter kann auch mit Polarisatoren gearbeitet werden.

Die Erfindung wird nachfolgend anhand eines Ausführungsbeispiels und anhand der Zeichnung näher erläutert. Die Figuren sind nicht massstäblich gezeichnet.

### Beschreibung der Figuren

- Fig. 1: zeigt einen Montageautomaten mit einer Flipvorrichtung und einem Spiegel, wobei sich die Flipvorrichtung und der Spiegel in einer ersten Endposition befinden,
- Fig. 2: zeigt den Montageautomaten, wobei sich die Flipvorrichtung und der Spiegel in einer zweiten Endposition befinden,
- Fig. 3, 4: zeigen einen Antriebsmechanismus für die Flipvorrichtung und den Spiegel.

### Detaillierte Beschreibung der Erfindung

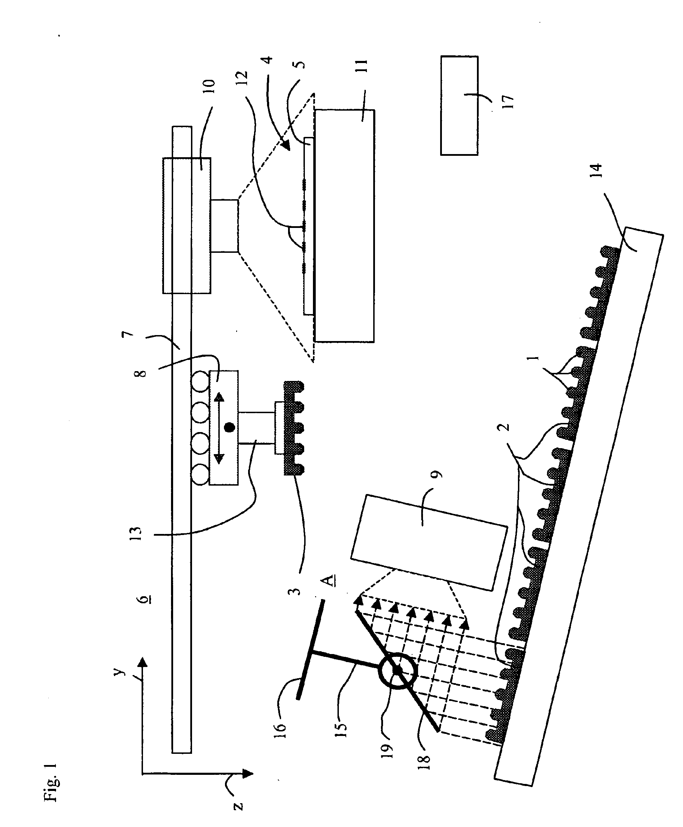

Die Fig. 1 zeigt in schematischer Darstellung ein Beispiel eines Montageautomaten für die Montage eines mit Bumps 1 versehenen Halbleiterchips 2, eines sogenannten Flipchips, auf einem Substratplatz 4 eines Substrats 5. Bei der in der Fig. 1 gezeigten Schnittdarstellung sind pro Halbleiterchip 2 fünf in einer Reihe nebeneinander liegende Bumps 1 sichtbar, denen auf dem Substratplatz 4 fünf in einer Reihe nebeneinander liegende Pads 12 entsprechen. Die Koordinaten eines kartesischen Koordinatensystems sind mit x, y und z bezeichnet, wobei die x-Koordinate senkrecht zur Zeichenebene verläuft. Der Montageautomat umfasst ein sogenanntes Pick and Place System 6 mit einem entlang einer in y-Richtung verlaufenden Achse 7 hin und her bewegbaren Bondkopf 8, und zwei Kameras 9 und 10 mit je einem zugehörigen Bildverarbeitungsmodul. Die Position des Bondkopfs 8 auf der Achse 7 wird mittels eines an sich bekannten und hier nicht näher erläuterten Positionsmess- und Regelkreises geregelt. Die Substrate 5 werden von einem Transportsystem in x-Richtung zu einer Bondstation 11 transportiert, wo der Bondkopf 8 jeweils einen Flipchip auf einem Substratplatz 4 absetzt, der den Bumps 1 zugeordnete elektrische Kontaktflächen, sogenannte Pads 12, aufweist. Der Bondkopf 8 enthält einen in z-Richtung auf und ab bewegbaren und um seine Längsachse, d.h. hier um die z-Achse drehbaren Chipgreifer 13. Die Halbleiterchips 2 werden im Beispiel auf einem Wafertisch 14 bereitestellt, wobei die Bumps 1 der Halbleiterchips 2 nach oben zeigen. Die Halbleiterchips 2 können auch mit ändern Mitteln wie "Waffelpack" oder "Tapes" bereitgestellt werden. Der Montageautomat umfasst weiter eine Flipvorrichtung 15 mit einem Greifer 16, sowie eine Steuer- und Recheneinheit 17, die den Montageautomaten steuert. Die Flipvorrichtung 15 ist zwischen zwei Endpositionen A und B hin und her drehbar. Der Wafertisch 14 ist so angeordnet, dass die Flipvorrichtung 15 zwischen dem Wafertisch 14 und dem Bondkopf 8 Platz findet. Die erste Kamera 9 erfüllt erfindungsgemäss zwei Funktionen: Sie bestimmt einerseits die Ist-Lage des vom Wafertisch 14 für die Montage bereitgestellten Halbleiterchips 2 und andererseits die Ist-Lage des vom Chipgreifer 13 des Bondkopfs 8 aufgenommenen Flipchips 3. Damit die erste Kamera 9 diese beiden Funktionen erfüllen kann, ist bei der Flipvorrichtung 15 ein Spiegel 18 angeordnet, der beim Wenden des Halbleiterchips 2 ebenfalls gedreht wird. Der Spiegel 18 ist im Blickfeld der ersten Kamera 9 angeordnet.

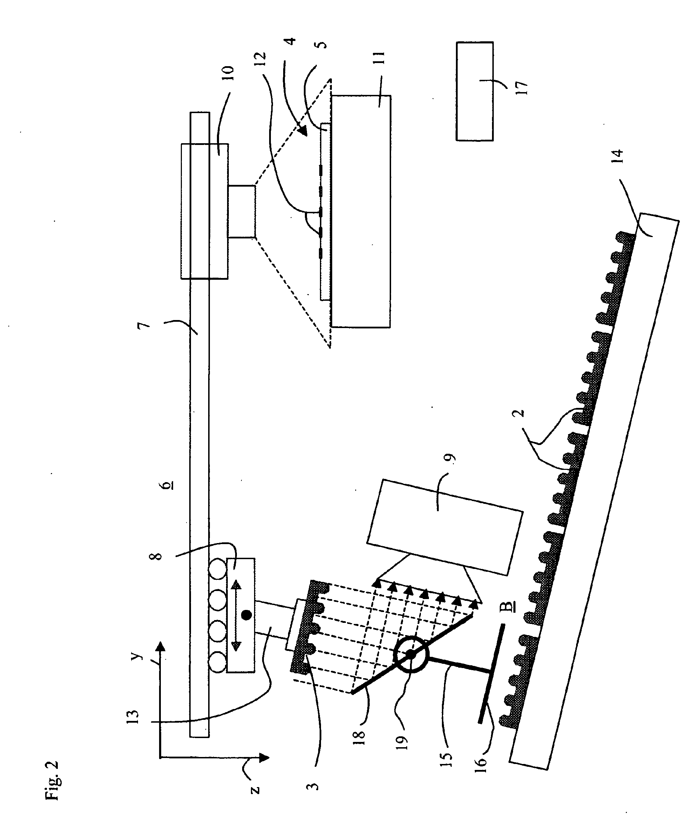

Die Flipvorrichtung 15 und der Spiegel 18 wechseln zwischen zwei Endpositionen A und B hin und her. In der Fig. 1 befinden sich die Flipvorrichtung 15 und der Spiegel 18 in der Endposition A, in dem der Greifer 16 zum Pick and Place System 6, der Spiegel 18 hingegen zum Wafertisch 14 gerichtet ist. Die erste Kamera 9 sieht somit den vom Wafertisch 14 bereitgestellten Halbleiterchip 2. In der Fig. 2 befinden sich die Flipvorrichtung 15 und der Spiegel 18 in der Endposition B, in dem der Greifer 16 zum Wafertisch 14, der Spiegel 18 hingegen zum Pick and Place System 6 gerichtet ist. Die erste Kamera 9 sieht somit den vom Chipgreifer 13 des Bondkopfs 8 gehaltenen Flipchip 3. Beim Wechsel von der Endposition A in die Endposition B wird der Greifer 16 um eine in x-Richtung verlaufende Achse 19 um den Winkel θ (in den Figuren nicht gezeigt) gedreht, der Spiegel 18 wird gleichzeitig um den halben Winkel θ/2 gedreht. Im Beispiel beträgt der Winkel θ = 180°. Der Winkel θ hängt von der Gesamtkonstruktion des Wafertisches 14 und des Pick and Place Systems 6 ab und kann daher auch einen anderen Wert als 180° aufweisen.

Die Flipvorrichtung 15 enthält zudem Beleuchtungsmittel, um in der Endposition A den vom Wafertisch 14 bereitgestellten Halbleiterchip 2 und in der Endposition B den vom Chipgreifer 13 des Bondkopfs 8 gehaltenen Flipchip 3 zu beleuchten. In der Endposition A ist eine direkte Beleuchtung, d.h. eine Beleuchtung mit Licht, das parallel zur optischen Achse verläuft und somit senkrecht auf den Halbleiterchip 2 auftrifft, möglich, während in der Endposition B eine indirekte Beleuchtung, d.h. eine Beleuchtung mit Licht, das schräg auf den Flipchip 3 auftrifft, von Vorteil ist.

Das Zusammenspiel von Flipvorrichtung 15, Spiegel 18 und erster Kamera 9 wird nun näher erläutert, wobei zunächst von folgendem Zustand ausgegangen wird: Die Flipvorrichtung 15 befindet sich in der ersten Endposition A, wie in der Fig. 1 dargestellt. Der Wafertisch 14 hat einen Halbleiterchip 2 für die Montage bereitgestellt. Der Chipgreifer 13 des Bondkopfs 8 hält einen Flipchip 3, dessen Bumps 1 benetzt worden sind und dessen Ist-Lage noch zu bestimmen ist. Der Chipgreifer 13 befindet sich oberhalb der Flipvorrichtung 15. Die Vorrichtung arbeitet wie folgt:
- Die erste Kamera 9 nimmt ein Bild des vom Wafertisch 14 bereitgestellten Halbleiterchips 2 auf und das zugehörige Bildverarbeitungsmodul bestimmt aus dem Bild die Ist-Lage des Halbleiterchips 2, sowie die Abweichung von der Soll-Lage des Halbleiterchips 2. Die Abweichung der Ist-Lage von der Soll-Lage ist durch drei Werte Δu, Δv und Δϕ festgelegt, wobei Δu und Δv wie üblich die Abweichung in zwei orthogonalen Richtungen und Δϕ die Abweichung der Drehlage bezeichnen.
- Sofern die drei Werte Δu, Δv und Δϕ vorbestimmte Grenzwerte nicht überschreiten, wird die Flipvorrichtung 15 in die zweite Endposition B gedreht, wo sie den bereitgestellten Halbleiterchip 2 ergreifen wird. Dieser Zustand ist in der Fig. 2 dargestellt. Der Bondkopf 8 wird in eine vorbestimmte Position gefahren. Die erste Kamera 9 nimmt ein Bild des vom Chipgreifer 13 des Bondkopfs 8 gehaltenen Flipchips 3 auf und das zugehörige Bildverarbeitungsmodul bestimmt aus dem Bild die Ist-Lage des Flipchips 3. Anschliessend platziert der Bondkopf 8 den Halbleiterchip auf dem Substrat 5 und kehrt in die vorbestimmte Position zurück, damit der Chipgreifer 13 den nächsten Halbleiterchip 2 von der Flipvorrichtung 15 übernehmen kann.
- Die Flipvorrichtung 15 wird in die erste Endposition A gedreht und übergibt den Halbleiterchip als Flipchip 3 an den Chipgreifer 13 des Bondkopfs 8. Der Bondkopf 8 bewegt, fakultativ, den Flipchip 3 zu einer Benetzungsstation, wo die Bumps 1 des Flipchips 3 mit Lotflussmittel benetzt werden, und wieder zurück in die Position oberhalb der Flipvorrichtung 15. Der Wafertisch 14 stellt den nächsten Halbleiterchip 2 für die Montage bereit.

Nun ist wieder die Ausgangslage erreicht und der nächste Zyklus beginnt.

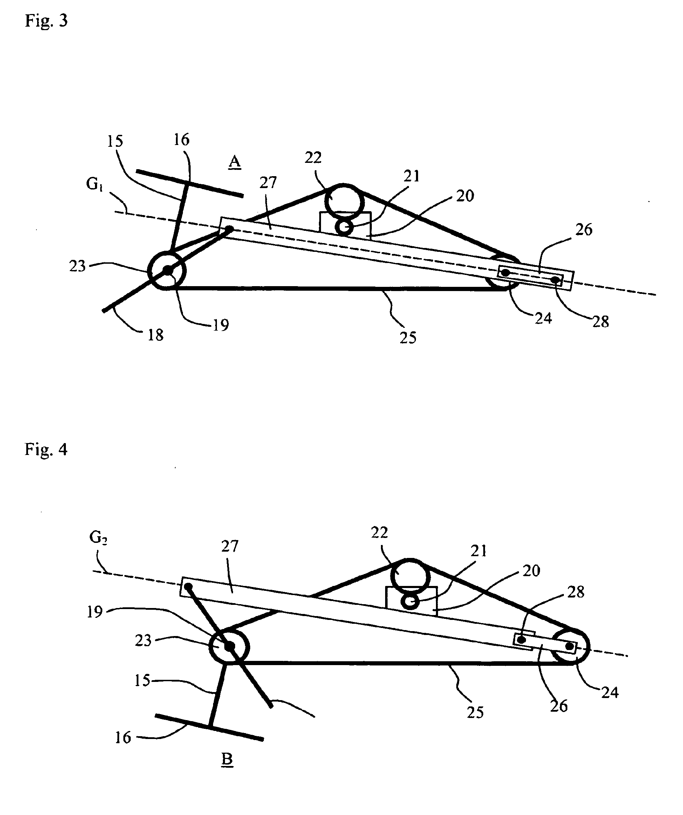

Die Fig. 3 und 4 zeigen einen vorteilhaften Antriebsmechanismus, der den Greifer 16 der Flipvorrichtung um den Winkel θ, im Beispiel um den Winkel θ = 180°, und den Spiegel 18 um den halben Winkel θ/2 dreht. Die Fig. 3 zeigt den Greifer 16 der Flipvorrichtung 15 und den Spiegel 18 in der Endposition A, die Fig. 4 zeigt den Greifer 16 der Flipvorrichtung 15 und den Spiegel 18 in der Endposition B. Der Antriebsmechanismus umfasst einen Motor 20, ein aus zwei Zahnrädern 21 und 22 gebildetes Untersetzungsgetriebe, ein drittes Zahnrad 23 und ein viertes Zahnrad 24, einen Zahnriemen 25 und zwei Hebel 26 und 27. Die vier Zahnräder 21 bis 24 sind um Achsen drehbar, die parallel zueinander und in x-Richtung, d.h. hier senkrecht zur Zeichenebene verlaufen. Der Greifer 16 der Flipvorrichtung 15 dreht mit dem dritten Zahnrad 23 mit. Ein erstes Ende des ersten Hebels 26 dreht mit dem vierten Zahnrad 24 mit, ein erstes Ende des zweiten Hebels 27 ist am Spiegel 18 befestigt und die beiden anderen Enden der beiden Hebel 26 und 27 sind an einem gemeinsamen Bolzen 28 drehbar gelagert. Das dritte Zahnrad 23 und das vierte Zahnrad 24 sind gleich gross. Wenn also der Motor 20 das dritte Zahnrad 23 und den Greifer 16 via Zahnräder 21 und 22 und Zahnriemen 25 um 180° dreht, dann wird das vierte Zahnrad 24 ebenfalls um 180° gedreht. Die Länge L₁ des ersten Hebels 26 und die Länge L₂ des zweiten Hebels 27 sind so bemessen, dass sich die beiden Hebel 26 und 27 jeweils in Strecklage zueinander befinden, wenn der Spiegel 18 in der Endposition A oder in der Endposition B angelangt ist. Strecklage bedeutet, dass die beiden Hebel 26 und 27 auf einer gemeinsamen Geraden G, (Fig. 3) beziehungsweise G₂ (Fig. 4) liegen. Der erste Hebel 26 wirkt als Antriebshebel, der zweite Hebel 27 wirkt als Übertragungshebel. Dieser Antriebsmechanismus bietet folgende Vorteile:
- Ein einziger Motor genügt, um den Greifer 16 um den Winkel θ und den Spiegel 18 um den halben Winkel θ/2 zu drehen.
- Die Ausnutzung der Strecklage der beiden Hebel 26 und 27 hat zur Folge, dass die Drehlage des Spiegels 18 sowohl in der Endposition A als auch in der Endposition B mit hoher Genauigkeit reproduzierbar ist.
- Der Spiegel 18 erreicht eine mit hoher Genauigkeit reproduzierbare Drehlage, ohne dass Anschläge nötig sind, an denen der Spiegel 18 mechanisch ausgerichtet wird.

Ein alternativer Antriebsmechanismus umfasst einen Motor, der ein Keilriemenrad antreibt, das einen ersten Durchmesser aufweist. Das erste Keilriemenrad treibt ein zweites Keilriemenrad, das denselben Durchmesser aufweist und an dem der Spiegel angeordnet ist, und gleichzeitig ein drittes Keilriemenrad an, das einen halb so gossen Durchmesser aufweist und an dem die Flipvorrichtung angeordnet ist. Eine Drehung des ersten Keilriemenrades um 90° bewirkt dann eine Drehung des zweiten Keilriemenrades um 90° und eine Drehung des dritten Keilriemenrades um 180°.

Es ist auch möglich, den Antriebsmechanismus für die Drehung des Greifers 16 und die Drehung des Spiegels 18 mit zwei getrennten, voneinander unabhängigen Antrieben auszurüsten.

## Patentansprüche

1. Vorrichtung für die Montage eines Halbleiterchips (2) als Flipchip (3) auf einem Substrat (5), umfassend:
Mittel für die Zuführung des Halbleiterchips an eine vorbestimmte Position,
ein Pick and Place System (6) mit einem Bondkopf (8) mit einem Chipgreifer (13),
eine Kamera (9) zur Aufnahme eines Bildes, und
einen optischen Schalter (18), der dazu dient, für die Kamera abwechslungsweise ein erstes oder ein zweites Blickfeld einzustellen, wobei sich der von den genannten Mitteln bereitgestellte Halbleiterchip im ersten Blickfeld und der vom Chipgreifer gehaltene Halbleiterchip im zweiten Blickfeld befindet, **dadurch gekennzeichnet, dass** eine Flipvorrichtung (15) mit einem Greifer (16) verwendet wird, wobei die Flipvorrichtung um eine vorbestimmte Achse (19) drehbar gelagert ist und dazu dient, in einer ersten Drehlage den von den genannten Mitteln bereitgestellten Halbleiterchip (2) an der vorbestimmten Position aufzunehmen und in einer zweiten Drehlage als Flipchip an den Chipgreifer des Bondkopfs zu übergeben, und
wobei die Flipvorrichtung und der optische Schalter miteinander wirkverbunden sind dergestalt, dass bei einem Wechsel der Flipvorrichtung von der ersten Drehlage in die zweite Drehlage das Blickfeld der Kamera vom ersten Blickfeld zum zweiten Blickfeld wechselt.

2. Vorrichtung nach Anspruch 1, **dadurch gekennzeichnet, dass** die Wirkverbindung zwischen der Flipvorrichtung und dem optischen Schalter eine mechanische Wirkverbindung ist.

3. Vorrichtung nach Anspruch 1 oder 2, **dadurch gekennzeichnet, dass** der optische Schalter einen drehbar gelagerten Spiegel (18) umfasst.

## Claims

1. Apparatus for mounting a semiconductor chip (2) as a flip chip (3) on a substrate (5), comprising:
means for supplying the semiconductor chip to a predetermined position;
a pick-and-place system (6) with a bonding head (8) with a chip gripper (13);
a camera (9) for taking a picture, and
an optical switch (18) which is used for setting in an alternating manner a first or second field of view for the camera, with the semiconductor chip provided by the said means being located in the first field of view and with the semiconductor chip held by the chip gripper being located in the second field of view,
**characterized in that** a flipping apparatus (15) with a gripper (16) is used, with the flipping apparatus being held rotatably about a predetermined axis (19) and being used in a first rotational position to receive the semiconductor chip (2) which is provided by the said means at the predetermined position and in a second rotational position transfer the semiconductor chip as flip chip to the chip gripper of the bonding head; and
with the flipping apparatus and the optical switch being operatively connected with each other in such a way that in the case of a change of the flipping apparatus from the first rotational position to the second rotational position the field of view of the camera changes from the first field of view to the second field of view.

2. Apparatus according to claim 1, **characterized in that** the operative connection between the flipping apparatus and the optical switch is a mechanical operative connection.

3. Apparatus according to claim 1 or 2, **characterized in that** the optical switch comprises a rotatably held mirror (18).

## Revendications

1. Dispositif pour le montage d'une puce de semiconducteur (2) comme Flip Chip (3) sur un substrat (5), comportant :
un moyen pour l'apport de la puce de semiconducteur sur une position prédéterminée,
un système de prélévement et de mise en place (6) munie d'une tête de bonding (8) comportant un préhenseur de puce (13),
une caméra (9) pour la réception d'une image, et
un commutateur optique (18) qui sert à ajuster un premier ou un second champ de visibilité pour la caméra avec alternance, dans lequel la puce de semiconducteur mise à disposition par les moyens mentionnés se trouve dans le premier champ de visibilité et dans lequel la puce de semiconducteur maintenue par le préhenseur de puce se trouve dans le second champ de visibilité, **caractérisé en ce qu'**un dispositif pour Flip Chip (15) comportant un préhenseur (16) est utilisé, dans lequel le dispositif pour Flip Chip est monté avec faculté de rotation autour d'un axe prédéterminé (19) et sert à réceptionner la puce de semiconducteur (2) mise à disposition par les moyens mentionnés dans une première position de rotation sur la position prédéterminée et à la transmettre dans une seconde position de rotation comme Flip Chip sur le préhenseur de puces de la tête de bonding, et
dans lequel le dispositif pour Flip Chip et le commutateur optique sont reliés entre eux efficacement de telle sorte que, lors d'un changement du dispositif pour Flip Chip de la première position de rotation dans la seconde position de rotation, le champ de visibilité de la caméra change du premier champ de visibilité sur le second champ de visibilité.

2. Dispositif selon la revendication 1, **caractérisé en ce que** la liaison efficace entre le dispositif pour Flip Chip et le commutateur optique est une liaison efficace mécanique.

3. Dispositif selon l'une ou l'autre des revendications 1 et 2, **caractérisé en ce que** le commutateur optique comporte un miroir monté avec faculté de rotation (18).
